Europäisches Patentamt

European Patent Office

Office européen des brevets

(19)

(11) **EP 0 745 996 B1**

## (12) FASCICULE DE BREVET EUROPEEN

(45) Date de publication et mention
de la délivrance du brevet:
**07.04.1999 Bulletin 1999/14**

(51) Int Cl.⁶: **G11C 16/06**, H03K 4/02

(21) Numéro de dépôt: **96401155.5**

(22) Date de dépôt: **29.05.1996**

(54) **Générateur de rampe numérique**

Digitaler Rampengenerator

Digital ramp generator

(84) Etats contractants désignés:
**DE FR GB IT**

(30) Priorité: **31.05.1995 FR 9506498**

(43) Date de publication de la demande:
**04.12.1996 Bulletin 1996/49**

(73) Titulaire: **STMicroelectronics S.A.**
**94250 Gentilly (FR)**

(72) Inventeur: **Tailliet, François**
**93800 Epinay sur Seine (FR)**

(74) Mandataire: **Schmit, Christian Norbert Marie**
**Cabinet Ballot-Schmit**
**7, rue Le Sueur**
**75116 Paris (FR)**

(56) Documents cités:
**US-A- 5 315 547**

• **IEEE TRANSACTIONS ON CONSUMER ELECTRONICS, vol. 38, no. 4, Novembre 1992, NEW YORK US, pages 824-829, XP000324642 YOSHIOKA ET AL: "The development of a memory card for a digital still camera using a 4 Mbit NAND EEPROM"**
• **EDN ELECTRICAL DESIGN NEWS, vol. 17, no. 19, 1 Octobre 1972, NEWTON, MASSACHUSETTS US, pages 48-49, XP002013828 EDWIN E MORRIS: "Simple stair generator uses 1 IC and 3 transistors"**

**Description**

La présente invention se rapporte à un générateur de rampe numérique. Plus particulièrement, la présente invention se rapporte à un circuit qui procure une tension de sortie pratiquement linéaire qui peut être utilisée, par exemple, pour programmer des mémoires programmables électriquement sous forme de circuit intégré.

La programmation des mémoires programmables électriquement sous forme intégrée, généralement connues sous le nom d'EPROM, d'EEPROM ou d'EEPROM flash lorsqu'elles sont effacées par blocs, est connue des personnes expérimentées dans la technique. Ces mémoires sont programmées en utilisant une tension élevée HI-V qui est parfois obtenue à partir de l'alimentation en tension normale Vcc du circuit et qui est parfois obtenue à partir d'une tension élevée appliquée par un circuit externe. Dans le premier cas, un circuit, que l'on appelle de façon conventionnelle une pompe de charge, est utilisé pour produire une tension élevée HI-V dans le circuit intégré.

En outre, on sait dans la technique que la véritable tension de programmation VPP est obtenue à partir de la tension élevée à l'intérieur de la mémoire intégrée elle-même. Les tensions HI-V ou VPP sont de l'ordre de 15 V ou plus, alors que la tension Vcc, à partir de laquelle la tension VPP peut être obtenue, est inférieure à la tension VPP. Par exemple, la tension Vcc peut présenter une valeur caractéristique dans la plage de 1,5 V à 5 V. Alors que la tension HI-V est destinée à présenter une valeur élevée, la tension VPP doit procurer une rampe linéaire suivie d'une valeur en palier régulée à cette valeur élevée. De façon caractéristique, la durée de la rampe est de 500 microsecondes alors que la durée du palier est d'un même ordre.

L'un des problèmes associés à la programmation des mémoires mentionnées ci-dessus est que lorsque l'on accroit la tension de programmation VPP trop rapidement pendant sa rampe, la durée de vie des cellules mémoire est substantiellement réduite, du fait que le front montant de la tension VPP est directement appliqué aux cellules mémoire pendant la programmation. Une augmentation trop rapide de la tension VPP provoque un courant par effet tunnel trop fort dans les oxydes de grille des transistors à grille flottante qui constituent la cellule mémoire. Cet oxyde peut être endommagé. Afin d'éviter ces problèmes, un contrôle analogique de la rampe est prévu. Une solution de ce type est proposée dans le brevet des Etats-Unis US-A-5 175 706 Edme.

Les pompes de charge actuelles utilisées pour engendrer la tension de programmation HI-V, produisent toutes une vitesse de variation de cette tension, c'est-à-dire un dHI-V/dt, qui n'est pas constante. Dans la mesure où cette vitesse dHI-V/dt n'est pas constante, elle ne peut pas être utilisée par elle-même comme une tension VPP réelle. Elle tendrait à trop contraindre les cellules mémoire pendant l'accroissement initial de la tension HI-V. En particulier, la hauteur de variation du saut de la tension HI-V au début de son accroissement est supérieure à la hauteur de variation du saut de la tension vers la fin de son accroissement. La non linéarité de dHI-V/dt est due au fait que la tension de sortie de ce circuit suit une enveloppe qui est par nature exponentielle.

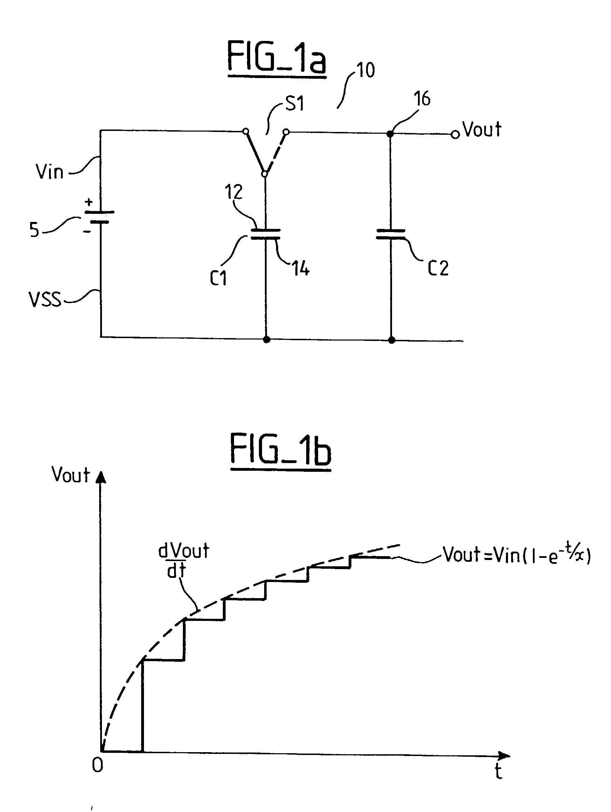

La figure 1a illustre une représentation d'un schéma de circuit de base d'un circuit de pompe de charge 10. Ce circuit de pompe de charge 10 comprend une alimentation en tension 5, procurant une tension Vin, un commutateur unipolaire à deux contacts S1 et des premier et second condensateurs C1, C2.

De façon à mettre en évidence ce problème de non linéarité, considérons un instant $t(n)$ où le commutateur S1 occupe sa première position indiquée par une ligne en traits pleins, reliant le condensateur C1 à l'alimentation en tension 5. De ce fait, la première plaque 12 du condensateur C1 est reliée à la borne de tension positive Vin de l'alimentation en tension 5. La seconde plaque 14 du condensateur C1 est reliée en permanence à la borne de tension négative VSS de l'alimentation en tension 5. Le second condensateur C2, lequel est isolé du condensateur C1, présente ses première et seconde plaques reliées entre une borne de sortie 16 du circuit de pompe de charge 10 et la borne de tension négative VSS. La borne de sortie 16 fournit la tension de sortie Vout. Ainsi, à l'instant $t(n)$, le condensateur C1 se charge jusqu'à la valeur de tension Vin, en supposant que VSS soit référencée à la masse, c'est-à-dire 0 V. Pendant cet intervalle de temps, le condensateur C2 supporte la tension $Vout(n)$ et la charge totale stockée par les condensateurs C1 et C2 est donnée par $Qt(n)=[C1.Vin + C2.Vout(n)]$.

Par suite, à l'instant $t(n+1)$, le commutateur S1 passe de sa première position à sa seconde position, la seconde position étant indiquée par des lignes en pointillés. Les condensateurs C1 et C2 sont à présent reliés en parallèle entre la borne de sortie 16 et la borne de tension négative VSS et les deux condensateurs (C1, C2) sont isolés de l'alimentation en tension 5. Ainsi, la charge totale qui a été stockée par les condensateurs C1 et C2 à l'instant $t(n)$, c'est-à-dire $Qt(n)$, est à présent partagée entre les condensateurs C1 et C2 et il en résulte que la tension Vout s'accroit depuis une valeur $Vout(n)$ vers une valeur $Vout(n+1)$. A partir du principe de la conservation de la charge, on obtient l'équation suivante :

$$(C1+C2).Vout(n+1)=(C1.Vin)+(C2.Vout(n)),$$

de ce fait

$$[Vout(n+1)-Vout(n)]=[C1/(C1+C2)].[Vin-Vout(n)] \hspace{3cm} (équation 1)$$

A partir de l'équation 1, on peut voir que le terme de gauche [Vout(n+1)-Vout(n)] décroît avec le temps du fait que le terme de droite Vout(n) s'approche de Vin.

La figure 1b illustre une représentation graphique de la vitesse de variation de la tension de programmation Vout en fonction du temps, c'est-à-dire dVout/dt. Il faut noter que la hauteur de variation initiale du saut de la tension Vout est beaucoup plus grande que la hauteur de variation du saut de la tension Vout vers la fin de son accroissement. La ligne en pointillés indique l'enveloppe de la vitesse de variation dVout/dt de la tension Vout, laquelle est donnée par Vout = Vin(1-exp(-t/x)), dans lequel x est proportionnel à [C1+C2]/C1.

Il est ainsi montré qu'un circuit de pompe de charge ne produit pas une rampe linéaire. Même si la tension d'alimentation est élevée, il n'en reste pas moins que sa rampe n'est pas linéaire et ne peut pas être utilisée telle quelle pour programmer des cellules mémoire de l'EPROM.

En fait, la tension VPP est produite, à partir d'une tension HI-V existante (à l'extérieur ou à l'intérieur du circuit intégré), par un circuit comportant un condensateur alimenté par une source de courant constant laquelle est alimentée par cette tension HI-V. Un tel circuit souffre des inconvénients d'être analogique et de la nécessité du contrôle du temps lorsque VPP atteint sa valeur nominale, et du contrôle de la durée d'une valeur en palier. Ceci est également obtenu par des circuits analogiques qui sont difficiles à régler à cause de la dispersion des caractéristiques.

Par conséquent, un but de la présente invention est d'engendrer une tension de rampe qui est obtenue à partir d'une tension donnée. La tension donnée peut, mais ceci n'est pas nécessaire, présenter une valeur inférieure à la tension de rampe nominale. Le moyen pour engendrer la tension de rampe comprend un moyen pour échantillonner la tension donnée et un moyen pour réguler la tension de rampe à une valeur souhaitée. Le moyen pour échantillonner la tension donnée est relié, commandé et encore dirigé de façon telle que la tension de rampe s'accroisse d'une façon commandée graduellement, l'accroissement graduel de la tension de rampe étant pratiquement linéaire. Un tel résultat est atteint par le générateur décrit dans le document US 5,315,547.

L'objet de la présente invention est de proposer une alternative à ce générateur de l'art antérieur.

En effet, la présente invention propose un générateur de rampe numérique comprenant un circuit d'échantillonnage commandé conforme à la partie caractérisante de la revendication 1.

Un circuit de commande commande les fonctionnalités des circuits d'échantillonnage, de transmission et élévateurs suivant des phases dans lesquelles,

a) l'échantillonnage de la tension d'entrée se produit une première fois,
b) une tension correspondant à la charge d'entrée échantillonnée est alors ajoutée à la tension d'entrée du circuit élévateur,
c) la tension d'addition résultante est alors transmise par le circuit de transmission vers la sortie du générateur.

Le but de la présente invention de même que d'autres buts, avantages et particularités seront mis en évidence à la lumière de la description détaillée suivante et des illustrations annexées, dont le but n'est pas limitatif, et dans lesquelles :

La figure 1a illustre une représentation déjà décrite d'un schéma d'un circuit de base d'un circuit de pompe de charge.

La figure 1b illustre une représentation graphique de la vitesse de variation de la tension de sortie Vout de la figure 1a.

La figure 2a illustre un générateur de rampe numérique conforme à la présente invention.

La figure 2b illustre la vitesse de variation de la tension de programmation de la figure 2a en fonction du temps.

La figure 2c illustre la relation de cadencement des signaux de commande des trois commutateurs tels que décrits en relation avec les figures 2a et 2b.

Les figures 3a, 3b et 3c illustrent un exemple d'un schéma de circuit du générateur de rampe numérique de la figure 2a.

La figure 4 représente les signaux utilisés pour commander les circuits des figures 3a à 3c.

La figure 5 représente un schéma synoptique d'un générateur de signal de commande qui est utilisé afin de produire les niveaux de tension de la figure 4.

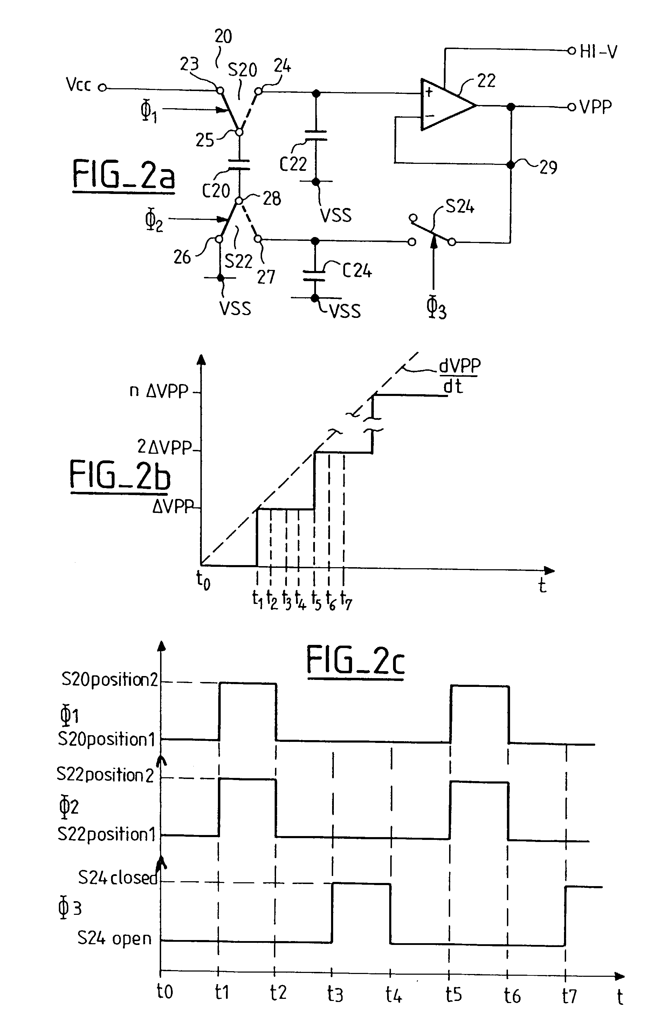

La figure 2a est une illustration représentative d'un générateur de rampe numérique conforme à la présente invention. Ce générateur de rampe numérique 20 comprend deux commutateurs unipolaires à deux contacts S20 et S22, un commutateur unipolaire à un contact S24, trois condensateurs C20, C22, C24 et un suiveur de tension 22.

Un premier contact du commutateur S20 repéré par le noeud 23 est relié à Vcc, son second contact est repéré par le noeud 24 et son noeud commun est repéré par le noeud 25. Dans une première position du commutateur S20, le noeud 25 est relié au noeud 23. Dans une seconde position, le noeud 25 est relié au noeud 24. Un premier contact du commutateur S22 est repéré par le noeud 26, son second contact est repéré par le noeud 27 et son noeud commun est repéré par le noeud 28. Dans une première position du commutateur S22, le noeud 28 est relié au noeud 26. Dans une seconde position, le noeud 28 est relié au noeud 27. Si le noeud 23 est relié à une entrée d'alimentation Vcc, le noeud 26 est relié à une entrée de masse, soit VSS. Le condensateur C22 est relié entre le noeud 24 et la tension de référence VSS. Le noeud 24 fournit une tension en rampe. Le suiveur de tension 22 reçoit cette tension en rampe sur une première entrée et procure une tension de sortie en rampe VPP sur sa borne de sortie 29. La borne de sortie 29 est reliée à une seconde entrée du suiveur de tension 22. Le suiveur de tension 22 pourrait être un amplificateur opérationnel relié en suiveur de tension. Schématiquement, le suiveur de tension 22 est alimenté par une tension d'entrée élevée HI-V. Le commutateur S24 est relié en série entre les noeuds 27 et 29 et le condensateur C24 est relié entre le noeud 27 et la référence de tension VSS. Le condensateur C20 est relié entre les noeuds 25 et 28 des commutateurs S20 et S22, respectivement. En pratique, une tension d'alimentation en programmation non régulée HI est régulée à sa valeur requise HI-V par des moyens non représentés.

Le fonctionnement de base du générateur de rampe 20 conforme à l'invention peut être décomposé en une série d'intervalles de temps. La description suivante ne prend en compte ni le seuil relativement petit et pratiquement constant, ni les pertes de commutation, etc.. A l'instant t0, (Figure 2b), on peut supposer que tous les condensateurs, C20, C22, C24 sont complètement déchargés, isolés physiquement les uns des autres, et que la valeur de la capacité du condensateur C24 est supérieure à celle de C22, dont la capacité est elle-même de valeur supérieure à celle de C20. En outre, les commutateurs S20, S22 et S24 sont supposés être commandés par les signaux de commande respectifs $\Phi$1, $\Phi$2 et $\Phi$3 apparaissant sur la figure 2c.

La figure 2b illustre la vitesse de variation de la tension de programmation de la figure 2a en fonction du temps.

Dans l'intervalle de temps défini par t0 < t < t1, les commutateurs S20 et S22 sont dans leur première position respective, comme indiqué par une ligne continue, et le commutateur S24 est ouvert : ainsi, les trois condensateurs C20, C22, C24 sont tous physiquement isolés les uns des autres. La plaque positive 25 du condensateur C20 se charge jusqu'à la valeur de tension Vcc, en supposant que la tension VSS est référencée par rapport à la masse par l'intermédiaire du commutateur S22.

A l'instant t1, les commutateurs S20 et S22 basculent, au même instant, ou pratiquement au même instant, depuis leur première position respective vers leur seconde position respective, comme indiqué par des lignes en pointillés; le commutateur S24 reste ouvert.

Dans l'intervalle de temps défini par t1 < t < t2 pendant lequel les commutateurs S20 et S22 sont dans leur seconde position respective et le commutateur S24 est ouvert, les condensateurs C24 et C20 sont maintenant reliés en série. En outre, cet ensemble de condensateurs C24 et C20 reliés en série est relié en parallèle avec le condensateur C22. La plaque positive 27 du condensateur C24 est reliée à la plaque négative 28 du condensateur C20. De ceci il résulte que la plaque positive 25 du condensateur C20 est amenée à un niveau de tension qui est supérieur au niveau de tension VPP disponible précédemment à la sortie du comparateur 22.

Cependant, au début, pendant ce premier intervalle de temps particulier, la tension aux bornes du condensateur C24 est de zéro Volt. De ce fait, aucune élevation de tension ne se produit. Néanmoins, à partir du principe de la conservation de charge, on peut obtenir l'équation suivante :

$$dVPP=VPP(t+1)-VPP(t)=[C20/(C20+C22)]Vcc. \qquad \text{Equation 2.}$$

Cette équation 2 reste vraie même pendant les cycles suivants. On notera que l'équation 2 ne contient pas de terme VPP(t) à droite, à la différence de l'équation 1. L'absence de terme VPP(t) dans le membre de droite de l'équation 2 est à l'origine de la grande amélioration de la linéarité de la pente de la tension VPP, c'est-à-dire dVPP/dt.

De ce fait, en intégrant l'équation 2 on obtient :

$$VPP = [C20/(C20+C22)].A.Vcc.t \qquad \text{(équation 3)}$$

dans laquelle A est une constante qui est proportionnelle à la fréquence de commutation des commutateurs S20 et S22.

Comme l'implique le terme suiveur de tension, la tension VPP sur la borne de sortie 29 du suiveur de tension 22 suit ou poursuit la tension sur sa borne d'entrée 24. De ce fait, comme la borne d'entrée du suiveur de tension 22 est reliée au noeud 24, la tension VPP sur la borne de sortie 29 du suiveur de tension 22 est pratiquement égale à la tension donnée par l'équation 3.

A l'instant t2, les commutateurs S20 et S22 basculent de leur seconde position respective et retournent vers leur première position respective, le commutateur S24 reste ouvert. Ainsi, les trois condensateurs, C20, C22, C24, sont à nouveau tous isolés les uns des autres. En outre, le condensateur C20 commence à nouveau à se charger vers la valeur de tension Vcc, il recommence à prendre un échantillon de la tension Vcc.

Dans l'intervalle défini par t2 < t < t3 : les commutateurs S20 et S22 sont dans leur première position respective, la plaque positive 25 du condensateur C20 se recharge à la valeur de tension Vcc. Le palier t2-t3 peut être très court par comparaison avec le palier t0-t1, t1-t2, ou le palier suivant t3-t4.

A l'instant t3, les commutateurs S20 et S22 restent toujours dans leur première position respective, le commutateur S24 se ferme et relie la borne de sortie 29 du suiveur de tension 22 à la plaque la plus positive 27 du condensateur C24.

Dans l'intervalle de temps défini par t3<t<t4, le condensateur C24 est chargé par la tension VPP du suiveur de tension présente sur la borne de sortie 29 du suiveur de tension 22. C'est-à-dire qu'il se charge pratiquement à la valeur de tension donnée par l'équation 3. Les charges électriques proviennent de l'alimentation HI-V.

A l'instant t4, les commutateurs S20 et S22 étant toujours dans leur première position respective, le commutateur S24 s'ouvre et déconnecte la borne de sortie 29 du suiveur de tension 22 de la plaque la plus positive 27 du condensateur C24, lequel conserve pratiquement sa charge.

Dans l'intervalle de temps défini par t4 < t < t5, les commutateurs S20 et S22 restent dans leur première position respective et le commutateur S24 reste ouvert. Il se produit un même phénomène que pendant l'intervalle de temps t0-t1, excepté que le noeud 27 n'est plus à VSS mais est amené à la valeur VPP.

A l'instant t5, les commutateurs S20 et S22 basculent de leur première position respective vers leur seconde position respective comme décrit ci-dessus pour l'instant t1.

Dans l'intervalle de temps défini par t5 < t < t6, les commutateurs S20 et S22 étant dans leur seconde position respective et le commutateur S24 étant ouvert, les condensateurs C20 et C24 en série sont à présent reliés à nouveau en série. Cet ensemble de condensateurs C20 et C24 est relié en parallèle avec le condensateur C22 comme décrit ci-dessus pour l'intervalle de temps t1 < t < t2. Cependant, pendant cet intervalle de temps le condensateur C24 se charge à la tension donnée par l'équation 3, soit VPP de telle sorte que le condensateur C24 élève la plaque négative du condensateur C20 jusqu'à cette valeur de tension. L'effet de pompage ou d'élevation est que la plaque négative 28 du condensateur C20 est toujours référencée par rapport à la tension VPP de programmation précédente lorsque les commutateurs S20 et S22 sont dans leur seconde position respective. Exprimé en termes plus généraux, le condensateur d'échantillonnage d'entrée C20 comporte toujours une plaque négative 28 référencée soit à la masse, soit, au moyen d'un condensateur d'élevation de sortie C24, à la valeur courante de la tension de sortie VPP de telle façon que la tension d'entrée Vcc soit ajoutée à la tension de sortie courante VPP.

A l'instant t6, les commutateurs S20 et S22 basculent de leur seconde position respective et retournent vers leur première position respective et le commutateur S24 reste ouvert comme décrit ci-dessus pour l'instant t2.

Dans l'intervalle de temps défini par t6 < t < t7 : les commutateurs S20 et S22 sont dans leur première position respective, le commutateur S24 est ouvert et les trois condensateurs C20, C22 et C24 se trouvent tous isolés physiquement les uns des autres. La plaque positive 25 du condensateur C20 se recharge à la valeur de tension Vcc.

A l'instant t7, le commutateur S24 se ferme et relie la borne de sortie 29 du suiveur de tension 22 à la plaque positive 27 du condensateur C24 comme décrit ci-dessus pour l'instant t3, et ainsi de suite.

La figure 2c illustre la relation de cadencement des signaux de commande respectifs Φ1, Φ2 et Φ3 des commutateurs respectifs S20, S22 et S24 comme décrits en relation avec les figures 2a et 2b. La durée d'un cycle va de l'instant tI à l'instant t5.

On notera, à partir de la figure 2c, qu'il n'est pas obligatoire d'inclure le commutateur S24. Il pourrait en théorie être remplacé par un court-circuit si les commutateurs S20 et S22 étaient commandés de telle façon que le commutateur S20 ne soit jamais dans sa première position lorsque le commutateur S22 est dans sa seconde position (et vice versa). Bien que cela conduise à un circuit instable dans certains cas, cela pourrait fonctionner.

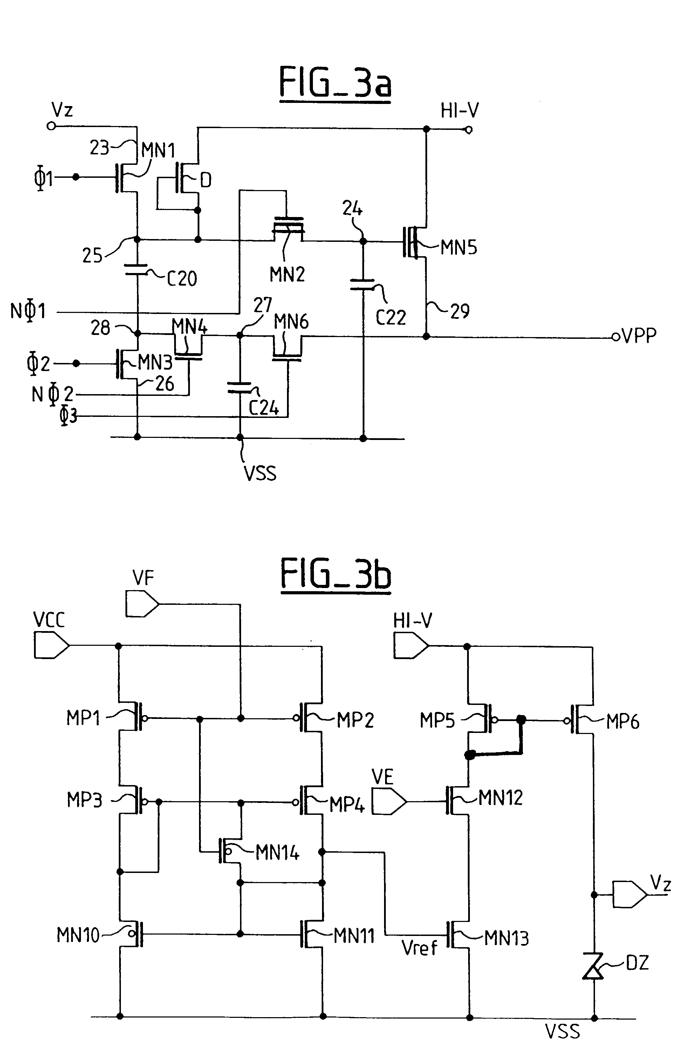

La figure 3a illustre un exemple d'un schéma de circuit du générateur de rampe numérique de la figure 2a. Ce schéma de circuit représente six transistors CMOS du type N MN1 à MN6, une diode D et les trois condensateurs C20, C22 et C24.

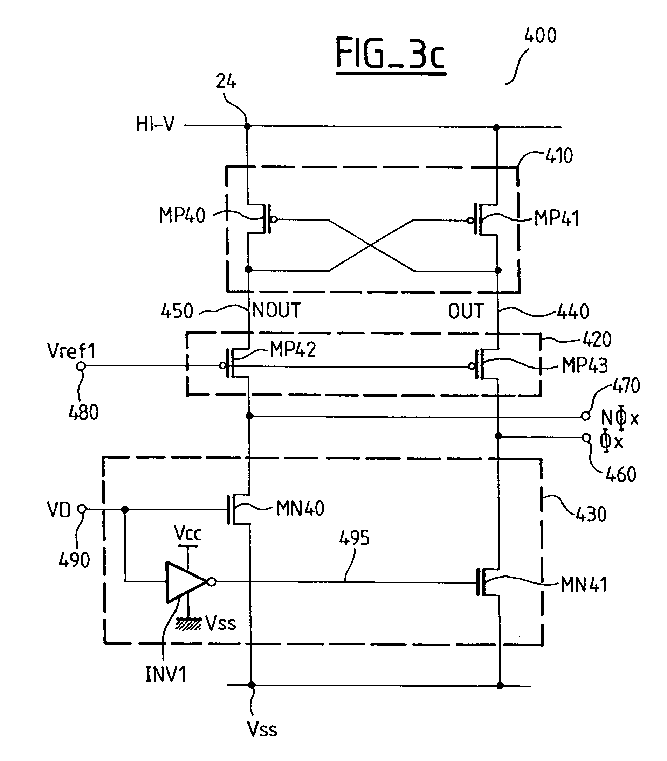

En se référant au transistor MN1, sa borne de source représente le noeud 23 et est reliée de préférence à une tension d'alimentation VZ. La tension VZ est produite par le circuit de la figure 3b. La valeur de VZ est de l'ordre de Vcc mais sous forme pulsée. La borne de drain de MN1 représente le noeud 25 et est reliée à la plaque positive du condensateur C20. En se référant au transistor MN2, sa borne de drain représente le noeud 25 et sa borne de source représente le noeud 24, lequel est relié à la plaque positive du condensateur C22. Les transistors MN1 et MN2 sont reliés et commandés de telle manière qu'ils représentent le commutateur S20 de la figure 2a. Les bornes de grille respectives des transistors MN1 et MN2 sont commandées par les signaux de commande respectifs Φ1 et NΦ1. Le signal NΦ1 est le signal inverse de Φ1. Ceux-ci sont engendrés par le circuit de la figure 3c.

En se référant au transistor MN3, sa borne de drain représente le noeud 28 et est reliée à la plaque négative du condensateur C20, sa borne de source représente le noeud 26 et est reliée à la borne de tension négative VSS. En se référant au transistor MN4, sa borne de source représente le noeud 28 et sa borne de drain représente le noeud 27, lequel est relié à la plaque positive du condensateur C24. Les transistors MN3 et MN4 sont reliés et commandés de telle façon qu'ils représentent le commutateur S22 de la figure 2a. Les bornes de grille respectives des transistors MN3 et MN4 sont commandées par les signaux de commande respectifs Φ2 et NΦ2. Le signal NΦ2 est le signal inverse de Φ2. Ceux-ci peuvent également être produits par le circuit de la figure 3c.

Le transistor MN5 est relié et commandé de telle façon qu'il représente le suiveur de tension 22 de la figure 2a. En se référant au transistor MN5, sa borne de drain est reliée, par l'intermédiaire de la diode D, au noeud 25, c'est-à-dire la plaque positive du condensateur C20. Sa borne de grille est reliée au noeud 24, c'est-à-dire la plaque positive du condensateur C22, et sa borne de source représente le noeud 29. Sa borne de drain est reliée à un noeud HI-V. La diode D est représentée par un transistor CMOS du type N branché en diode dans le sens direct dont l'anode, qui est reliée au noeud 25, est formée en reliant les bornes de grille et de drain ensemble, la cathode de cette diode, c'est-à-dire la borne de source, est reliée à la borne de drain du transistor MN5 et au noeud HI-V. Il est préférable d'inclure cette diode D dans la mesure où elle empêche toute surtension de se produire au noeud 25, laquelle peut être produite par l'effet d'élévation.

Le transistor MN6 est relié et commandé de telle façon qu'il représente le commutateur S24 de la figure 2a. En se référant au transistor MN6, sa borne de drain est reliée à la borne de source 29 du transistor MN5, sa borne de source est reliée à la plaque positive 24 du condensateur C24 et sa borne de grille est commandée par le signal de commande Φ3.

Les signaux de commande Φ1, NΦ1, Φ2, NΦ2 et Φ3 sont de préférence obtenus à partir de circuits qui sont alimentés à partir de la tension élevée HI-V, comme décrit ci-après.

Il faut noter que les transistors MN1 à MN6 sont des transistors CMOS symétriques et que leurs bornes de drain et de source respectives peuvent être respectivement interchangées. En outre, il est préférable que les transistors MN2 et MN5 soient des transistors MOS du type N natif c'est-à-dire, des transistors qui n'ont pas fait l'objet d'ajustement de tension de seuil de grille (Vth) et, en conséquence, ont un seuil de conduction faible.

La figure 3b représente un circuit utilisé de préférence pour produire une tension à une valeur VZ. Du fait que des charges électriques identiques constituent le principe de base d'un signal de rampe linéaire, le condensateur d'échantillonnage C20 doit être alimenté de préférence par une tension constante.

Comme représenté, l'alimentation VZ est produite par une diode Zener DZ, reliée entre un noeud de tension HI-V et un noeud de tension VSS, en série avec un transistor CMOS du type P MP6. En outre, un tel circuit consommant du courant, il est préférable qu'il soit commuté par un signal cyclique VE. Le signal VE permet la conduction du circuit MP6-DZ uniquement lorsque C20 doit être chargé : lorsque les commutateurs S20 et S22 basculent vers leur première position.

De façon caractéristique, cette conduction se produit pendant trois microsecondes toutes les 16 microsecondes. La conduction est obtenue au moyen d'un miroir de courant comprenant le transistor MP6 dans la branche de la diode DZ et un transistor MP5 dans une branche comprenant en outre une série de deux transistors MOS du type N MN12 et MN13. Le transistor MN12 est utilisé pour conditionner la conduction de la diode DZ à la réception de signaux VE sur sa grille. La grille du transistor MP5 est connectée à la grille du transistor MP6 et à son propre drain. Le transistor MP5 agit comme un générateur de courant dont la valeur est fixée par une tension constante Vref apparaissant sur la grille du transistor MN13. La tension constante Vref est elle-même produite par un circuit miroir de WILSON classique comprenant des transistors CMOS du type P MP1 à MP4 et des transistors CMOS du type N MN10, MN11 et MN14. Ce miroir de WILSON est lui-même commuté par un signal VF qui est appliqué à la grille du transistor de copie MP1 et MP2. Lorsqu'une tension VPP n'est pas nécessaire, VF est à VZ et les transistors MP1 et MP2 sont bloqués. Lorsque VPP est nécessaire, VF est fixé à VSS. Le fait d'avoir une tension Vref stable, laquelle attaque un circuit qui lui-même procure une tension stable VZ, permet d'obtenir un courant de conduction faible dans la diode DZ sans subir les inconvénients d'une modification de la tension DZ dûs à une modification de ce courant faible.

La figure 3c représente un circuit inverseur haute tension destiné à engendrer les signaux de commande à tension élevée Φx et NΦx. Dans le circuit de l'invention, deux circuits de ce type sont nécessaires pour attaquer les commutateurs S20 et S24 respectivement.

L'inverseur haute tension 400 représenté comprend : un étage croisé 410; un étage cascode 420; et un étage de commutation 430. Il procure les signaux de tension élevée complémentaires Φx, NΦx.

L'étage croisé 410 est relié à la tension HI-V et procure deux signaux de sortie complémentaires à tension élevée OUT et NOUT sur ses bornes de sortie respectives 440 et 450. L'étage croisé 410 comporte deux transistors MOS du type P croisés MP40 et MP41 dont les sources sont reliées à la tension HI-V. La grille du transistor MP40 est reliée au drain 440 du transistor MP41 et la grille du transistor MP41 est reliée au drain 450 du transistor MP40.

Deux entrées respectives de l'étage cascode 420 sont reliées aux sorties respectives 440 et 450 de l'étage croisé 410. L'étage cascode 420 fournit les signaux de commande complémentaires à tension élevée Φx et NΦx sur ses bornes respectives 460 et 470. L'étage cascode 420 comprend deux transistors MOS du type P MP42 et MP43 dont les bornes de source sont respectivement reliées aux bornes de drain des transistors MP40 et MP41 et dont les bornes de grille sont polarisées par l'intermédiaire de la borne 480 par une tension de référence Vref1.

Vref1 est égale à HI-V moins environ 5 volts. Les drains des transistors MOS MP40 et MP41 de l'étage 410 sont ainsi polarisés de façon à ne pas être à une tension trop basse. Ceci limite le courant de commutation et accroit de ce fait l'efficacité puisque le circuit est alimenté par la source de tension HI-V dont la sortance est faible.

Deux bornes d'entrée respectives de l'étage de commutation 430 sont reliées aux bornes de sortie respectives 460 et 470 de l'étage cascode 420. L'étage de commutation 430 est commandé par l'intermédiaire d'une troisième borne d'entrée 490, par un signal de commande d'entrée VC ou VD (selon les signaux Φ1 ou Φ2 à produire) et est relié à la source de tension VSS. Les niveaux de tension des signaux de commande d'entrée VC ou VD sont de préférence obtenus à partir de la source de tension Vcc.

L'étage de commutation 430 comprend deux transistors MOS du type N MN40 et MN41 et un inverseur INV1, de préférence un inverseur CMOS. Les bornes de drain des transistors MN40 et MN41 sont respectivement reliées aux bornes de source des transistors MP42 et MP43. Les signaux de commande VC ou VD sont appliqués à la borne de grille du transistor MN40 et à la borne d'entrée de l'inverseur INV1. La borne de grille du transistor MN41 est reliée à la borne de sortie 495 de l'inverseur INV1. Un pôle d'alimentation haute de l'inverseur INV1 est relié à la source de tension VCC, alors que le pôle d'alimentation basse de l'inverseur INV1 est relié à la source de tension VSS.

Du fait que le fonctionnement du circuit inverseur de haute tension 400 est symétrique, seul son fonctionnement dans un état logique stable haut, c'est-à-dire un niveau de tension de VCC, présent sur la borne de grille 490 du transistor MN40 sera envisagé, puisqu'une personne expérimentée dans la technique peut facilement déduire le cas inverse.

De ce fait, le transistor MN40 est conducteur alors que le transistor MN41 n'est pas conducteur. Ainsi, le transistor MN40 abaisse la tension sur la borne de drain 470 du transistor MP42 jusqu'à un niveau approximativement égal à VSS. Du fait que le transistor MP42 (et en fait le transistor MP43) est commuté par Vrefl par l'intermédiaire de la borne 480, il est conducteur, il en résulte que la tension du noeud 450 est abaissée jusqu'à un niveau approximativement égal à VPP-Vref1+Vtp. Le supplément Vtp est dû au fait que les caissons dans lesquels sont fabriqués les transistors P MP40 etMP43 sont portés à HI-V. Du fait que les bornes respectives de drain et de grille des transistors respectifs MP40 et MP41 sont croisées, l'action d'abaisser la tension de l'une des grilles de l'un de ces transistors entraîné la tension de l'autre à s'élever, ainsi des signaux complémentaires OUT et NOUT sont procurés. Dans ce mode de réalisation particulier, le signal de commande Φx est à un niveau de tension approximativement égal à VPP, alors que le signal de commande NΦx est à un niveau de tension approximativement égal à VSS. Les signaux Φx et NΦx sont en opposition de phase alors que les signaux Φx et VC ou VD sont en phase.

A partir de la figure 3a, on peut voir que le signal de commande Φ2 peut être le signal de commande Φ1 et le signal de commande NΦ2 peut être le signal de commande NΦ1. Ainsi, ces quatre signaux de commande Φ1, NΦ1, Φ2, NΦ2 peuvent être obtenus à partir d'un même circuit convertisseur de niveau de tension; le signal de commande Φ3 étant obtenu à partir d'un autre inverseur de haute tension. En variante, les signaux de commande Φ1, NΦ1 et Φ2, NΦ2 peuvent être obtenus à partir d'inverseurs de haute tension différents. En outre, il est possible que le transistor MN6 de la figure 3a soit commandé par le signal de commande NΦ2 (ou NΦ1) à la place de Φ3.

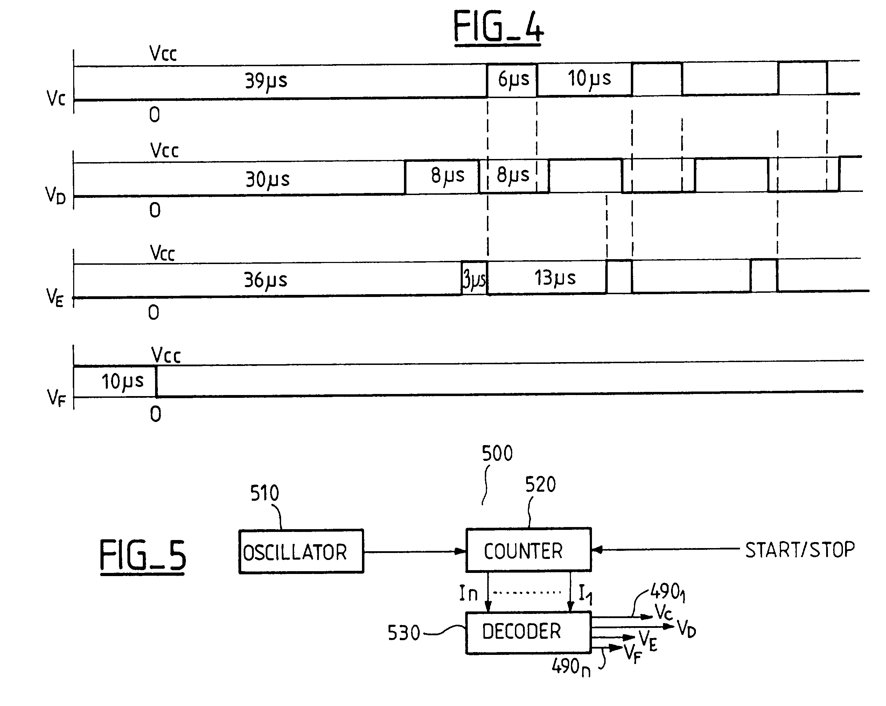

La figure 4 représente des chronogrammes des signaux VC, VD, VE et VF présentés ci-dessus. VF est bas lorsqu'une sortie VPP doit être produite sous forme d'une rampe. VE, lequel déclenche la conduction de DZ, est actif à la fin d'une impulsion active VD, qui elle-même déclenche les commutateurs S20 et S22. Ainsi, lorsque VD est actif, et dès que VE devient actif, le condensateur C20 se charge. Ensuite, lorsque VD est bas, VC s'élève jusqu'à une tension élevée. Une tension élevée correspondant à VC est appliquée à MN6 agissant en tant que commutateur S24. Sur un niveau VC actif, S24 est fermé.

La figure 5 représente un schéma synoptique d'un générateur de signal de commande 500 qui est utilisé pour engendrer les signaux de la figure 4. Le générateur 500 comprend un oscillateur 510, un compteur 520 et un décodeur 530.

L'oscillateur 510 attaque le compteur 520 et le décodeur 530 reçoit du compteur 520 une pluralité de signaux en entrée I1 à In et le décodeur 530 délivre une pluralité de signaux de commande VC à VF qui présentent les relations de cadencement appropriées. Le décodeur 530 et le compteur 520 sont connus des personnes expérimentées dans la technique.

Le fonctionnement du générateur de rampe numérique peut être commandé par un signal MARCHE/ARRET qui est reçu par le compteur 520.

De ce fait, à condition que la sortie de l'oscillateur 510 soit stable, la vitesse de variation de la tension de programmation VPP, c'est-à-dire dVPP/dt, ne dépendra que du rapport des capacités C20 et C22, c'est-à-dire C20/C22, qui est un rapport de surfaces qui peut être maîtrisé avec précision. Comme résultat de cette dépendance du rapport des surfaces des condensateurs C20 et C22, le générateur de rampe numérique conforme à l'invention est indépendant de toutes variations de processus, de température et de tension d'alimentation (VCC) et la tension de programmation VPP à la sortie 24 du générateur de rampe numérique est pratiquement linéaire.

**Revendications**

1. Générateur de rampe numérique comprenant un circuit d'échantillonnage commandé caractérisé en ce qu'il comporte :

   - un circuit de transmission, ou circuit suiveur de tension (22);
   - un premier condensateur (C24) qui est chargé à une tension de sortie (Vpp) courante du circuit suiveur de tension (22);
   - un deuxième condensateur (C20) relié en série entre un premier (S20) et un deuxième (S22) commutateurs unipolaires à deux contacts,
   - un troisième condensateur (C22) relié entre une première entrée du circuit suiveur de tension (22) et l'entrée de masse (Vss);
   - un circuit de commande générant des signaux de commande ($\Phi 1, \Phi 2$) des commutateurs (S20,S22) tels que, dans une première position respective (23,26) des commutateurs, ledit deuxième condensateur (C20) est relié entre une entrée d'alimentation (Vcc) et l'entrée de masse (Vss) en sorte qu'il se charge à une tension d'alimentation (Vcc,figure 2a;VZ,figures 3a et 3b), alors que, dans une deuxième position respective (24,27) des commutateurs, il est relié en série avec le premier condensateur (C24) en sorte que la tension d'alimentation (Vcc) est ajoutée à la tension de sortie (Vpp) courante du circuit suiveur de tension, ledit premier (C24) et ledit deuxième (C20) condensateurs étant alors reliés en parallèle avec le troisième condensateur (C22) en sorte qu'une nouvelle tension de sortie du circuit suiveur de tension (22) est générée qui est supérieure à ladite tension de sortie courante.

2. Générateur selon la revendication 1, caractérisé en ce que le premier condensateur (C24) est relié entre la borne de sortie (29) du circuit suiveur de tension (22) et l'entrée de masse (VSS).

3. Générateur selon la revendication 1, caractérisé en ce qu'il comprend un troisième commutateur (S24) unipolaire à un contact relié en série entre la borne de sortie (29) du circuit suiveur de tension (22) et une première plaque (27) du premier condensateur (C24) dont la seconde plaque est reliée à l'entrée de masse (VSS).

4. Générateur selon l'une des revendications précédentes, caractérisé en ce que :

   - le premier commutateur (S20) comporte une première borne (23) reliée à l'entrée d'alimentation (Vcc), une seconde borne (24) reliée à une entrée du circuit suiveur de tension (22) et une troisième borne commune (25) reliée à une première plaque du deuxième condensateur (C20);
   - le deuxième commutateur (S22) comporte une première borne (26) reliée à l'entrée de masse (VSS), une seconde borne (27) reliée à la première plaque (27) du premier condensateur (C24) et une troisième borne commune (28) reliée à une seconde plaque du deuxième condensateur (C20).

5. Générateur de rampe numérique selon la revendication 4, caractérisé en ce que le circuit de commande fait basculer chacun desdits premier et deuxième commutateurs (S20, S22), depuis leur première borne respective (23, 26) vers leur seconde borne respective (24, 27) simultanément ou pratiquement simultanément.

6. Générateur selon l'une quelconque des revendications 3 à 5, caractérisé en ce que le circuit de commande fait basculer le troisième commutateur (S24) dans sa position fermée après que lesdits premier et deuxième commutateurs (S20, S22) aient basculé chacun vers leur première borne respective (23, 26) et dans sa position ouverte avant que lesdits second et troisième commutateurs (S20, S22) aient basculé chacun vers leur seconde borne respective (24, 27).

7. Générateur de rampe numérique selon l'une quelconque des revendications précédentes, caractérisé en ce que ledit circuit suiveur de tension comprend un transistor MOS (MN5) qui comporte :

   - une borne de drain reliée à un noeud délivrant tension élevée (HI-V),
   - une borne de source reliée à la borne de sortie (29) du générateur, et
   - une borne de grille qui est reliée à la seconde borne (24) du premier commutateur (S20).

8. Générateur de rampe numérique selon la revendication 7, caractérisé en ce que ledit circuit suiveur de tension comprend en outre une diode (D) dont l'anode est reliée à la troisième borne commune (25) du deuxième commutateur (S20) et dont la cathode est reliée à la borne de drain du transistor MOS (MN5).

9. Générateur de rampe numérique selon la revendication 8, caractérisé en ce que la diode (D) est réalisée en utilisant un transistor MOS.

10. Générateur de rampe numérique selon l'une quelconque des revendications précédentes, caractérisé en ce que les premier et deuxième commutateurs (S20, S22) comprennent des transistors MOS du type N reliés et commandés de façon appropriée.

11. Générateur de rampe numérique selon l'une quelconque des revendications précédentes, caractérisé en ce que la capacité du deuxième condensateur (C20) est inférieure à la capacité du troisième condensateur (C22) et en ce que la capacité du troisième condensateur (C22) est inférieure à la capacité du premier condensateur (C24).

12. Générateur de rampe numérique selon l'une quelconque des revendications 1 à 9, caractérisé en ce qu'il est réalisé sur un substrat semi-conducteur monolithique.

13. Utilisation d'un générateur de rampe numérique selon l'une quelconque des revendications 1 à 10, caractérisée en ce que la tension de sortie (VPP) du circuit suiveur de tension (22) alimente un dispositif de programmation d'une mémoire.

14. Circuit intégré de carte à puce, caractérisé en ce qu'il comprend un générateur de rampe numérique selon l'une quelconque des revendications 1 à 12.


**Patentansprüche**

1. Digitaler Rampengenerator, der einen geregelten Meßkreis umfaßt, dadurch gekennzeichnet, daß er umfaßt:

   - eine Übertragungsschaltung oder Spannungsleitungsschaltung (22),
   - einen ersten Kondensator (C24), der mit einer üblichen Ausgangsspannung (Vpp) der Spannungsleitungsschaltung (22) aufgeladen wird,
   - einen zweiten Kondensator (C20), der in Serie zwischen einem ersten (S20) und einem zweiten (S22) einpoligen Schalter mit zwei Kontakten geschaltet ist,
   - einen dritten Kondensator (C22), der zwischen einem ersten Eingang der Spannungsleitungsschaltung (22) und dem Masseeingang (VSS) geschaltet ist,
   - eine Steuerschaltung, die Steuersignale ($\phi$1, $\phi$2) der Schalter (S20, S22) erzeugt, so daß in einer ersten entsprechenden Position (23, 26) der Schalter der zweite Kondensator (C20) zwischen einem Versorgungseingang (Vcc) und dem Masseeingang (Vss) geschaltet ist, so daß er sich mit einer Versorgungsspannung (Vcc, Figur 2a; VZ, Figuren 3a und 3b) auflädt, während er in einer zweiten entsprechenden Position (24, 27) der Schalter in Serie mit dem ersten Kondensator (C24) geschaltet ist, so daß die Versorgungspannung (Vcc) zur üblichen Ausgangsspannung (VPP) der Spannungsleitungsschaltung hinzukommt, wobei der erste (C24) und der zweite (C20) Kondensator dann parallel mit dem dritten Kondensator (C22) geschaltet sind, so daß eine neue Ausgangsspanung der Spannungsleitungsschaltung (22) erzeugt wird, die über der genannten üblichen Ausgangsspannung liegt.

2. Generator nach Anspruch 1, dadurch gekennzeichnet, daß der erste Kondensator (C24) zwischen der Ausgangsklemme (29) der Spannungsleitungsschaltung (22) und dem Masseeingang (VSS) geschaltet ist.

3. Generator nach Anspruch 1, dadurch gekennzeichnet, daß er einen dritten einpoligen Schalter (S24) mit einem Kontakt umfaßt, der in Serie zwischen der Ausgangsklemme (29) der Spannungsleitungsschaltung (22) und einer ersten Platte (27) des ersten Kondensators (C24) geschaltet ist, dessen zweite Platte an dem Masseeingang (VSS) angelegt ist.

4. Generator nach einem der vorstehenden Ansprüche, dadurch gekennzeichnet, daß:

   - der erste Schalter (S20) eine erste Klemme (23) umfaßt, die an den Versorgungseingang (Vcc) angelegt ist, eine zweite Klemme (24), die an einen Eingang der Spannungsleitungsschaltung (22) angelegt ist, und eine dritte, gemeinsame Klemme (25), die an eine erste Platte des zweiten Kondensators (C20) angelegt ist;
   - der zweite Schalter (S22) eine erste Klemme (26) umfaßt, die an den Masseeingang (VSS) angelegt ist, eine zweite Klemme (27), die an die erste Platte (27) des ersten Kondensators (C24) angelegt ist, und eine dritte, gemeinsame Klemme (28), die an eine zweite Platte des zweiten Kondensators (C20) angelegt ist.

5. Digitaler Rampengenerator nach Anspruch 4, dadurch gekennzeichnet, daß die Steuerschaltung den ersten und den zweiten Schalter (S20, S22) gleichzeitig oder praktisch gleichzeitig von ihrer jeweiligen ersten Klemme (23, 26) zu ihrer jeweiligen zweiten Klemme (24, 27) kippen läßt.

6. Generator nach einem der Ansprüche 3 bis 5, dadurch gekennzeichnet, daß die Steuerschaltung den dritten Schalter (S24) in seine geschlossene Position kippen läßt, nachdem der erste und zweite Schalter (S20, S22) jeweils in Richtung auf ihre erste jeweilige Klemme (23, 26) gekippt sind, und in seine offene Position, bevor der erste und zweite Schalter (S20, S22) jeweils in Richtung auf ihre zweite jeweilige Klemme (24, 27) gekippt sind.

7. Digitaler Rampengenerator nach einem der vorstehenden Ansprüche, dadurch gekennzeichnet, daß die erste Spannungsleitungsschaltung einen MOS-Transistor (MN5) aufweist, der umfaßt:

   - einen Drain-Anschluß, die an einen Netzknoten angelegt ist, der Hochspannung (HI-V) liefert,
   - einen Source-Anschluß, der an die Anschlußklemme (29) des Generators angelegt ist, und
   - einen Gate-Anschluß, der an die zweite Klemme (24) des ersten Schalters (S20) angelegt ist.

8. Digitaler Rampengenerator nach Anspruch 7, dadurch gekennzeichnet, daß die Spannungsleitungsschaltung ferner eine Diode (D) aufweist, deren Anode an die dritte gemeinsame Klemme (25) des zweiten Schalters (S20) angelegt ist, und deren Kathode an den Drain-Anschluß des MOS-Transistors (MN5) angelegt ist.

9. Digitaler Rampengenerator nach Anspruch 8, dadurch gekennzeichnet, daß die Diode (D) durch Verwendung eines MOS-Transistors hergestelt wird.

10. Digitaler Rampengenerator nach einem der vorstehenden Ansprüche, dadurch gekennzeichnet, daß der erste und zweite Schalter (S20, S22) MOS-Transistoren des N-Typs umfassen, die in geeigneter Weise geschaltet und gesteuert werden.

11. Digitaler Rampengenerator nach einem der vorstehenden Ansprüche, dadurch gekennzeichnet, daß die Kapazität des zweiten Kondensators (C20) geringer ist als die Kapazität des dritten Kondensators (C22), sowie dadurch, daß die Kapazität des dritten Kondensators (C22) geringer ist als die Kapazität des ersten Kondensators (C24).

12. Digitaler Rampengenerator nach einem der Ansprüche 1 bis 9, dadurch gekennzeichnet, daß er auf einem monolithischen Halbleitersubstrat ausgeführt ist.

13. Verwendung eines digitalen Rampengenerators nach einem der Ansprüche 1 bis 10, dadurch gekennzeichnet, daß die Ausgangsspannung (VPP) der Spannungsleitungsschaltung (22) eine Vorrichtung zur Programmierung eines Speichers versorgt.

14. Integrierte Schaltung einer Chipkarte, dadurch gekennzeichnet, daß sie einen digitalen Rampengenerator nach einem der Ansprüche 1 bis 12 umfaßt.

## Claims

1. Digital ramp generator comprising a controlled sampling circuit, characterised in that it has:

   - a transmission circuit, or voltage follower circuit (22),

   - a first capacitor (C24) which is charged at a normal output voltage (Vpp) of the voltage follower circuit (22);

   - a second capacitor (C20) connected in series between first (S20) and second (S22) single-pole switches with two contacts,

   - a third capacitor (C22) connected between a first input of the voltage follower circuit (22) and the earth input (Vss);

- a control circuit generating control signals ($\Phi$1,$\Phi$2) for the switches (S20, S22) such that, in a first respective position (23, 26) of the switches, the said second capacitor (C20) is connected between a supply input (Vcc) and the earth input (Vss) so that it is charged at a supply voltage (Vcc, Figure 2a; VZ, Figures 3a and 3b), whereas, in a second respective position (24, 27) of the switches, it is connected in series with the first capacitor (C24) so that the supply voltage (Vcc) is added to the normal output voltage (Vpp) of the voltage follower circuit, the said first (C24) and second (C20) capacitors then being connected in parallel with the third capacitor (C22) so that a new output voltage of the voltage follower circuit (22) is generated which is higher than the said normal output voltage.

2. Generator according to Claim 1, characterised in that the first capacitor (C24) is connected between the output terminal (29) of the voltage follower circuit (22) and the earth input (VSS).

3. Generator according to Claim 1, characterised in that it comprises a third single-pole switch (S24) with one contact connected in series between the output terminal (29) of the voltage follower circuit (22) and a first plate (27) of the first capacitor (C24), whose second plate is connected to the earth input (VSS).

4. Generator according to one the preceding claims, characterised in that:

- the first switch (S20) has a first terminal (23) connected to the supply input (Vcc), a second terminal (24) connected to an input of the voltage follower circuit (22) and a third common terminal (25) connected to a first plate of the second capacitor (C20);

- the second switch (S22) has a first terminal (26) connected to the earth input (VSS), a second terminal (27) connected to the first plate (27) of the first capacitor (C24) and a third common terminal (28) connected to a second plate of the second capacitor (C20).

5. Digital ramp generator according to Claim 4, characterised in that the control circuit causes each of the said first and second switches (S20, S22) to switch from the first respective terminal (23, 26) to their respective second terminal (24, 27) simultaneously or practically simultaneously.

6. Generator according to any one of Claims 3 to 5, characterised in that the control circuit causes the third switch (S24) to switch into its closed position after the said first and second switches (S20, S22) have each switched to their respective first terminal (23, 26) and into its open position before the said second and third switches (S20, S22) have each switched to their respective second terminal (24, 27).

7. Digital ramp generator according to any one of the preceding claims, characterised in that the said voltage follower circuit comprises an MOS transistor (MN5) which has:

- a drain terminal connected to a node delivering high voltage (HI-V),

- a source terminal connected to the output terminal (29) of the generator, and

- a gate terminal which is connected to the second terminal (24) of the first switch (S20).

8. Digital ramp generator according to Claim 7, characterised in that the said voltage follower circuit also comprises a diode (D) whose anode is connected to the third common terminal (25) of the second switch (S20) and whose cathode is connected to the drain terminal of the MOS transistor (MN5).

9. Digital ramp generator according to Claim 8, characterised in that the diode (D) is produced using an MOS transistor.

10. Digital ramp generator according to any one of the preceding claims, characterised in that the first and the second switches (S20, S22) comprise n-type MOS transistors connected and controlled in a suitable fashion.

11. Digital ramp generator according to any one of the preceding claims, characterised in that the capacitance of the second capacitor (C20) is less than the capacitance of the third capacitor (C22) and in that the capacitance of the third capacitor (C22) is less than the capacitance of the first capacitor (C24).

12. Digital ramp generator according to any one of Claims 1 to 9, characterised in that it is produced on a monolithic semiconductor substrate.

13. Use of a digital ramp generator according to any one of Claims 1 to 10, characterised in that the output voltage (Vpp) of the voltage follower circuit (22) supplies a memory programing device.

14. Chip-card integrated circuit, characterised in that it comprises a digital ramp generator according to any one of Claims 1 to 12.

## FIG_1a

## FIG_1b

$$V_{out} = V_{in}(1 - e^{-t/x})$$

$$\frac{dV_{out}}{dt}$$

FIG_2a

FIG_2b

FIG_2c

# FIG_3a

# FIG_3b

# FIG_3c

## FIG_4

$V_C$ — Vcc / 0

39 µs | 6 µs | 10 µs

$V_D$ — Vcc / 0

30 µs | 8 µs | 8 µs

$V_E$ — Vcc / 0

36 µs | 3 µs | 13 µs

$V_F$ — Vcc / 0

10 µs

## FIG_5

510 — OSCILLATOR

500 — 520 — COUNTER ← START/STOP

$I_n$ ......... $I_1$

530 — DECODER

$490_1$ $V_C$ $V_D$
$V_E$
$490_n$ $V_F$

EP 0 745 996 B1